# EUROPÄISCHE PATENTSCHRIFT

(11) **EP 2 404 052 B1**
(45) Veröffentlichungstag und Bekanntmachung des Hinweises auf die Patenterteilung: **04.01.2017**
(21) Anmeldenummer: 10707215.9
(22) Anmeldetag: 26.02.2010
(51) Int. Cl.: F02G 5/00, H01L 35/30, F02G 5/02

(54) **ABSCHIRMTEIL ZUR WÄRMEABSCHIRMUNG VON MOTOREN ODER MOTORKOMPONENTEN, INSBESONDERE HITZESCHILD FÜR VERBRENNUNGSKRAFTMASCHINEN**
STRUCTURAL ELEMENT FOR THERMALLY SHIELDING ENGINES OR ENGINE COMPONENTS, IN PARTICULAR A HEAT SHIELD FOR COMBUSTION ENGINES
COMPOSANT STRUCTURAL POUR BOUCLIER THERMIQUE DE MOTEURS OU DE COMPOSANTS DE MOTEURS, EN PARTICULIER BOUCLIER THERMIQUE POUR MOTEURS À COMBUSTION INTERNE

(30) Priorität: 04.03.2009 DE 102009012841
(43) Veröffentlichungstag der Anmeldung: 11.01.2012
(73) Patentinhaber: ElringKlinger AG, 72581 Dettingen (DE)
(72) Erfinder: ZIKA-BEYERLEIN, Beate, 90482 Nürnbeg (DE)
(74) Vertreter: Oberdorfer, Jürgen
(86) Internationale Anmeldenummer: PCT/EP2010/001206
(87) Internationale Veröffentlichungsnummer: WO 2010/099901

(56) Entgegenhaltungen:
- DE-A1-102006 039 024
- DE-A1-102008 022 802
- US-A1- 2006 101 822

## Beschreibung

Die Erfindung betrifft ein Strukturbauteil zur Wärmeabschirmung von Motoren oder Motorkomponenten, insbesondere Hitzeschild für Verbrennungskraftmaschinen, wobei das Strukturbauteil eine flächige Ausdehnung hat und eine erste Seite aufweist, die einem heißen Bauteil des Motors zugewandt ist, und eine zweite Seite aufweist, die dem heißen Bauteil des Motors abgewandt ist.

Das Wärmemanagement beispielsweise in Fahrzeugen und damit auch die Anforderungen an thermische und akustische Abschirmsysteme ist komplex, da sich moderne Motoren durch immer höhere Leistungsdichte bei immer kleinerem Raumangebote auszeichnen. Faktoren wie Fahrzeugdesign, Luftwiderstand und Systeme zur Insassensicherung geben den zur Verfügung stehenden Platz vor. Gleichzeitig muss eine steigende Zahl von Bauteilen berücksichtigt werden, beispielsweise aufgrund der höheren Ansprüche an die Abgasqualität, des größeren Bedarfs an elektronischen Komponenten zur Motor- und Nebenaggregatesteuerung und nicht zuletzt aufgrund der Erwartungen der Endkunden hinsichtlich des Komforts. Durch das begrenzte Platzangebot wird die zum Abtransport der Hitze erforderliche Kühlluftzirkulation behindert. Ein Großteil der Komponenten muss daher vor zu hohen Temperaturen geschützt werden.

Die primäre Funktion von Abschirmteilen liegt im Schutz temperaturempfindlicher Bauteile. Hitzequellen im Fahrzeug sind beispielsweise die abgasführenden Teile wie Abgaskrümmer, Turbolader, Katalysatoren, Rußpartikelverbrennungssysteme und dergleichen. Überwiegend handelt es sich bei den Abschirmteilen oder Hitzeschildern um dreidimensionale Freiformflächenbauteile, die auch als Strukturbauteil bezeichnet werden können. Das Abschirmteil soll einerseits so nah wie möglich an der Hitzequelle platziert werden, um die Umgebung vor den im Betrieb entstehenden Wärmeenergien, sei es nun durch Strahlung oder durch Konvektion, zu schützen. Durch die bekannten Hitzeschilder wird die Wärme abgeschirmt, wobei gleichzeitig mit der Wärmeabschirmung auch eine Schalldämmung bewirkt werden kann.

Aus der DE 10 2007 005 520 A1 ist ein Fahrzeug mit einem thermoelektrischen Generator bekannt, der ein mit der Wärme abgebenden Komponente thermisch gekoppeltes Wärme aufnehmendes Element aufweist und der aus dem Temperaturgefälle zwischen dem Wärme aufnehmenden Element und einer Wärmesenke elektrische Energie erzeugt. Der thermoelektrische Generator ist dabei unmittelbar an der Wärme abgebenden Komponente angeordnet und thermisch leitend mit dieser verbunden.

Aus der DE 10 2007 035 931 A1 ist eine Anordnung für einen thermoelektrischen Generator bekannt, bestehend aus einer hochtemperaturseitigen Grundplatte und einer niedertemperaturseitigen Grundplatte, mit einer zwischen den Grundplatten angeordneten Halbleitermatrix, wobei die nierdertemperaturseitige und die hochtemperaturseitige Grundplatte eine im Wesentlichen zweidimensionale Abmessung aufweisen und wobei die hochtemperaturseitige Grundplatte mit einer heißen Oberfläche stoffschlüssig verbindbar ist und/oder die niedertemperaturseitige Grundplatte mit einer kalten Oberfläche stoffschlüssig verbindbar ist.

Die DE 10 2006 039 024 A1 (D2) offenbart einen sogenannten Thermogenerator mit ringförmigen, thermoelektrischen Elementen. Diese thermoelektrischen Elemente sind bei bestimmungsgemäßen Gebrauch ein Abgasrohr umgebend angeordnet. Die Wärme des in dem Rohr vorhandenen Luftstroms wird dabei mittels Wärmeleitung über die thermisch leitende Barriereschicht an den thermoelektrischen Generator leitend übertragen.

Der Erfindung liegt die Aufgabe zugrunde, ein Strukturbauteil, insbesondere ein Hitzeschild für Motoren bereitzustellen, das einen vergrößerten Funktionsumfang aufweist. In einer Ausführungsart der Erfindung soll die abgeschirmte Wärme zur Energierückgewinnung eingesetzt werden.

Diese Aufgabe ist durch das im Anspruch 1 bestimmte Strukturbauteil gelöst. Besondere Ausführungsarten der Erfindung sind in den Unteransprüchen bestimmt.

In einer Ausführungsart weist das Strukturbauteil einen thermoelektrischen Generator auf, mit dem aus einer sich im Betrieb des Motors ergebenden Temperaturdifferenz zwischen der ersten Seite und der zweiten Seite des Strukturbauteils elektrische Energie erzeugbar ist. Vorzugsweise ist die elektrische Energie unmittelbar aus der Temperaturdifferenz und insbesondere ohne bewegende oder drehende Teile erzeugbar. Der thermoelektrische Generator kann zwischen der ersten Seite und der zweiten Seite des Strukturbauteils angeordnet sein, insbesondere unmittelbar wärmeleitend mit der ersten Seite einerseits und der zweiten Seite andererseits verbunden sein. Für die Energiewandlung kann beispielsweise der sogenannte Seebeck-Effekt eingesetzt werden, wonach Ladungsträger von einem warmen Ende zu einem kalten Ende eines Leiters oder Halbleiters diffundieren. Durch die Kombination unterschiedlicher Werkstoffe oder unterschiedlich dotierter Werkstoffe, insbesondere unterschiedlich dotierter Halbleiterwerkstoffe, kann an den freien Enden eines miteinander verbundenen Leiterpaares eine Spannung abgegriffen werden, die abhängig von der Temperaturdifferenz ist. Als mögliche Werkstoffe für den thermoelektrischen Generator kommen beispielsweise Bismuttellurid (Bi2Te3), Bleitellurid (PbTe) oder Silicium-Germanium (SiGe) in Betracht und darüber hinaus alle derzeit bekannten und zukünftig noch zu entwickelnden Werkstoffe, die eine ausreichende Thermokraft aufweisen.

Vorteilhaft ist eine gute Wärmeankopplung der Warm- bzw. Kaltseite des thermoelektrischen Generators mit den entsprechenden ersten und zweiten Seiten des Strukturbauteils. Soweit für das Strukturbauteil Aluminium als Werkstoff verwendet wird, insbesondere einzelne Aluminiumlagen, kann das Strukturbauteil an den thermoelektrischen Generator angeformt sein oder der thermoelektrische Generator kann in flächige Anlage an die entsprechende Seite des Strukturbauteils gebracht sein. Das Strukturbauteil kann aus einem Blech, insbesondere Aluminiumblech, mit einer Dicke von weniger als 1 mm gebildet sein oder aus mehreren Blechlagen zusammengesetzt sein und an die Kontur des thermoelektrischen Generators angepasst sein. Erforderlichenfalls kann auf der zugehörigen Anlagefläche des thermoelektrischen Generators und/oder der Anlagefläche des Strukturbauteils eine elektrisch isolierende Schicht aufgebracht sein, im Falle von Aluminium als Werkstoff für das Strukturbauteil beispielsweise aus Aluminiumoxyd. Das Strukturbauteil auch mindestens bereichsweise, vorzugsweise ganzflächig, eloxiert sein.

In einer Ausführungsart weist der thermoelektrische Generator einen ersten Abschnitt und einen zweiten Abschnitt auf, die jeweils ein erstes Ende und ein zweites Ende aufweisen. Die beiden Abschnitte können aus unterschiedlichen Werkstoffen oder Werkstoffkombinationen hergestellt sein und/oder können unterschiedlich dotiert sein. Bei halbleitenden Werkstoffen können die beiden Abschnitte unterschiedlich dotiert sein, d. h. in unterschiedlicher Weise gezielt mit Fremdatomen verunreinigt sein, insbesondere solchen Fremdatomen, die auf Kristallgitterplätzen eingebaut sind. Beide Abschnitte können aus demselben Werkstoff hergestellt sein, wobei ein Abschnitt n-dotiert ist und der andere Abschnitt p-dotiert ist.

Die ersten Enden der beiden Abschnitte können elektrisch miteinander verbunden und in wärmeleitender Verbindung mit einer der beiden Seiten des Strukturbauteils sein, beispielsweise mit der dem heißen Bauteil des Motors zugewandten ersten Seite. Die elektrische Verbindung der ersten Enden der beiden Abschnitte kann auch unmittelbar durch das Strukturbauteil selbst erfolgen. Die zweiten Enden der beiden Abschnitte können in wärmeleitender Verbindung mit der anderen der beiden Seiten des Strukturbauteils sein, insbesondere mit der dem heißen Bauteil des Motors abgewandten zweiten Seite des Strukturbauteils. Zwischen den zweiten Enden der beiden Abschnitte liegt eine elektrische Spannung an, wenn zwischen den beiden Seiten des Strukturbauteils eine Temperaturdifferenz besteht.

Die von dem thermoelektrischen Generator bereitgestellte Energie kann in das Bordnetz beispielsweise eines Fahrzeuges eingespeist werden, wodurch entweder unmittelbar elektrische Verbraucher des Fahrzeuges betrieben werden können oder die elektrische Energie kann in dem in der Regel im Fahrzug vorhandenen elektrochemischen Energiespeicher gespeichert werden. In beiden Fällen ergibt sich eine erhebliche Einsparung des Kraftstoffverbrauches des Motors. Vorteilhaft ist, dass das erfindungsgemäße Strukturbauteil verhältnismäßig großflächig die Wärmeleistung des Motors, die bisher an die Umwelt abgegeben wird und damit verloren geht, aufnehmen kann und in elektrische Energie umwandeln kann. Die zunehmende Tendenz der Entwicklung vollverkapselter Motoren wirkt sich dabei vorteilhaft auf die Höhe der erzeugbaren elektrischen Energie aus.

In einer Ausführungsart weist der thermoelektrische Generator voneinander beabstandete Abschnitte auf, beispielsweise thermoelektrische Schenkel, wobei der Bereich zwischen den Abschnitten mindestens teilweise durch einen thermischen Isolationswerkstoff ausgefüllt sein kann. Im einfachsten Fall kann es sich dabei um ein Gas handeln. Die Verwendung eines Schaumes oder eines Silicons bietet den Vorteil, dass das Eindringen von Feuchtigkeit in den thermoelektrischen Generator zuverlässig verhindert wird. Diese Feuchtigkeit führt zum einen zu einer erhöhten Wärmeleitfähigkeit zwischen der Kaltseite und der Warmseite des thermoelektrischen Generators, die grundsätzlich unerwünscht ist, und zum anderen kann die Feuchtigkeit auch Korrosion hervorrufen, die ebenfalls unerwünscht ist. Vorzugsweise liegt der Isolationswerkstoff vollflächig an den Abschnitten des thermoelektrischen Generators an.

In einer Ausführungsart ist das Strukturbauteil mehrlagig, wobei eine erste Lage die erste Seite bildet und eine zweite Lage die zweite Seite des Strukturbauteils bildet. Der thermoelektrische Generator kann zwischen den beiden Lagen angeordnet sein und mit beiden Lagen in wärmeleitender Verbindung sein. Bei der ersten und/oder zweiten Lage kann es sich um eine Folie oder ein Blech handeln. An einer ersten Fläche der ersten Lage kann eine Warmseite des thermoelektrischen Generators in Anlage sein. Eine der ersten Fläche gegenüberliegende zweite Fläche der ersten Lage kann dem heißen Bauteil des Motors zugewandt sein. Eine erste Fläche der zweiten Seite kann in Anlage an einer Kaltseite des thermoelektrischen Generators sein. Eine der ersten Fläche gegenüberliegende zweite Fläche der zweiten Lage kann von dem heißen Bauteil des Motors abgewandt sein. Das Strukturbauteil kann auch mehrere Lagen aufweisen, und es können mehrere thermoelektrische Generatoren nebeneinander zwischen zwei Lagen angeordnet sein, oder hintereinander in der Form einer Kaskade angeordnet sein.

In einer Ausführungsart überlappen die beiden Lagen des Strukturbauteils den thermoelektrischen Generator. In einem an den thermoelektrischen Generator angrenzenden Bereich können die beiden Lagen voneinander thermisch isoliert sein. Insbesondere können die beiden Lagen in einem an dem thermoelektrischen Generator angrenzenden Bereich durch einen thermischen Isolationswerkstoff voneinander beabstandet sein. Der Isolationswerkstoff kann auch als Abstandshalter dienen, gegebenenfalls auch um Druckkräfte aufzunehmen und von dem thermoelektrischen Generator abzuhalten. Der Isolationswerkstoff kann durch einen ausgehärteten Kunststoff oder durch einen ausgehärteten Schaum gebildet sein.

In einer Ausführungsart sind elektrische Anschlussleitungen des thermoelektrischen Generators mindestens abschnittsweise zwischen zwei Lagen des Strukturbauteils geführt. Die Anschlussleitungen können durch Drahtleitungen, Blechstreifen oder auch durch auf die Lagen aufgebrachte Leiterbahnen gebildet sein. In jedem Fall ergibt sich durch die Anordnung zwischen den Lagen des Strukturbauteils ein Schutz der Anschlussleitungen gegenüber Beschädigungen durch mechanische oder thermische Einflüsse.

In einer Ausführungsart weist mindestens eine der beiden Lagen des Strukturbauteils auf ihrer dem thermoelektrischen Generator zugewandten Seite eine Anschlusselektrode zur elektrischen Kontaktierung des thermoelektrischen Generators und/oder elektrische Leiterbahnen auf. Insbesondere können die Anschlusselektroden oder die Leiterbahnen unmittelbar auf eine der Lagen des Strukturbauteils aufgebracht werden, beispielsweise in Dünn- oder Dickschichttechnik aufgedruckt, aufgedampft oder auf sonstige Weise aufgebracht sein. Dadurch kann auf einfache Weise auch eine Verbindung von Anschlusselektroden untereinander realisiert werden, ohne dass es einer Verdrahtung der Abschnitte des thermoelektrischen Generators bedarf. Auch die Anzahl der Kontakt- und Verbindungsstellen ist dadurch minimiert.

In einer Ausführungsart weist die erste Seite des Strukturbauteils mindestens bereichsweise eine die Wärmeabsorption und/oder die Wärmeaufnahme fördernde Beschichtung und/oder Oberflächentopographie auf. Dadurch ist gewährleistet, dass die erste Seite möglichst viel Wärmeenergie aufnimmt, die anschließend mittels des thermoelektrischen Generators in elektrische Energie umgewandelt werden kann. Eine die Wärmeaufnahme fördernde Beschichtung kann beispielsweise durch eine schwarze oder dunkle Färbung, insbesondere durch eine schwarze Eloxierung, bereitgestellt sein. Durch eine Oberflächentopographie kann zudem die für eine Wärmeabsorption zur Verfügung stehende Oberfläche vergrößert sein. Alternativ oder ergänzend können auch Antireflexionsschichten auf die Oberfläche aufgebracht sein.

In einer Ausführungsart weist die zweite Seite des Strukturbauteils mindestens bereichsweise eine die Wärmeabstrahlung und/oder Wärmeableitung fördernde Beschichtung und/oder Oberlfächentopographie auf. Auf diese Weise kann die Temperatur der zweiten Seite minimiert werden und dadurch die Energiegewinnung mittels des thermoelektrischen Generators erhöht werden. Eine die Wärmeabstrahlung fördernde Beschichtung kann beispielsweise durch eine schwarze oder dunkle Färbung, insbesondere durch eine schwarze Eloxierung, bereitgestellt werden. Durch eine Oberflächentopographie kann die für die Wärmeableitung bereitgestellte Oberfläche vergrößert sein.

In einer Ausführungsart weist das Strukturbauteil einen Anschlussabschnitt auf, an dem die von dem thermoelektrischen Generator erzeugte elektrische Energie abgreifbar ist. Der Anschlussabschnitt kann mindestens eine flächige Anschlusselektrode aufweisen, die für eine Verbindung mit einer Anschlussleitung an oder nahe einer Randfläche des Strukturbauteils vorgesehen sein kann. Die Anschlussleitung kann beispielsweise steckbar oder lösbar klemmbar sein, so dass bei einem Ausbau des Strukturbauteils auf einfache Weise die elektrische Verbindung aufgehoben werden kann. Alternativ oder ergänzend kann der Anschluss beispielsweise durch Crimpen, Nieten oder Schweißen erfolgen. In einer Ausführungsart wird bereits durch den Einbau des Strukturbauteils, insbesondere durch die Montage des Strukturbauteils, eine Elektrode des thermoelektrischen Generators mit dem elektrischen Bordnetz verbunden, beispielsweise indem eine Elektrode des thermoelektrischen Generators elektrisch leitend mit dem Fahrzeugchassis verbunden wird, das eine Bezugselektrode oder die Masseelektrode bilden kann. Dadurch ist nur noch eine weitere Elektrode des thermoelektrischen Generators mit dem Bordnetz zu verbinden.

In einer Ausführungsart weist das Strukturbauteil einen Kompensationsabschnitt auf, mittels dem eine temperaturbedingte Änderung der Ausdehnung des Strukturbauteils derart kompensierbar ist, dass ein Festlegeabschnitt zum Befestigen des Strukturbauteils und/oder der Anschlussabschnitt keine unzulässig hohen mechanischen Spannungen erfährt. Zu diesem Zweck kann der Kompensationsabschnitt Oberflächenstrukturen wie beispielsweise Falten oder Sicken aufweisen, so dass sich der Kompensationsabschnitt im Falle einer temperaturinduzierten Ausdehnungsänderung beispielsweise wie ein Faltenbalg verformen kann. Durch den Kompensationsabschnitt kann auch ein Schutz des thermoelektrischen Generators vor temperaturinduzierten mechanischen Spannungen bereitgestellt werden. Dies ist insbesondere dann vorteilhaft, wenn der thermoelektrische Generator aus einem spröden Werkstoff hergestellt ist.

In einer Ausführungsart ist der thermoelektrische Generator mindestens teilweise in Dick- oder Dünnschichttechnik hergestellt. Die thermoelektrischen Abschnitte und/oder die elektrisch leitenden Verbindungen und/oder die elektrisch leitenden Anschlussflächen des thermoelektrischen Generators können in Dick- oder Dünnschichttechnik hergestellt sein. Insbesondere die elektrisch leitenden Verbindungen und die elektrisch leitenden Anschlüsse können flächig auf das Strukturbauteil aufgebracht sein, beispielsweise auf eine zugehörige Lage des Strukturbauteils. Das Aufbringen kann beispielsweise durch Aufdrucken, Aufdampfen, Abscheiden oder auf sonstige Weise erfolgen. Die Lagen des Strukturbauteils bilden mindestens abschnittsweise elektrische Anschluss- und/oder Verbindungselektroden. In einer Ausführungsart ist der thermoelektrische Generator mindestens teilweise in einem im Wesentlichen planen Zustand auf das Strukturbauteil aufgebracht, das erst anschließend in seine endgültige Form gebogen wird.

In einer Ausführungsart ist der thermoelektrische Generator mindestens teilweise durch polymerelektronische thermoelektrische Abschnitte gebildet. Alternativ oder ergänzend können mindestens die Anschluss- und Verbindungsleitungen durch polymerelektrische Abschnitte gebildet sein. Ein Vorteil des Einsatzes der Polymerelektronik besteht nicht nur in der hohen Formfreiheit der herzustellenden Elemente, sondern vor allem auch in der vergleichsweise geringen thermischen Leitfähigkeit, wodurch der Wirkungsgrad des thermoelektrischen Generators erhöht ist. Thermoelektrische Werkstoffe können beispielsweise in Partikelform in ein Polymer eingebracht werden, das anschließend auf das Strukturbauteil aufgebracht wird, beispielsweise aufgedruckt wird.

In einer Ausführungsart ist der thermoelektrische Generator durch Anschluss an eine elektrische Energiequelle auch als Wärmepumpe betreibbar. Dadurch können in dem Wirkungsbereich des Strukturbauteils liegende Motorteile temperiert werden, beispielsweise aus dem kalten Zustand vorgeheizt oder auf einer konstanten Temperatur gehalten werden, wodurch die Motoreffizienz und/oder die Abgasreinigung verbessert werden kann.

Weitere Vorteile, Merkmale und Einzelheiten der Erfindung ergeben sich aus den Unteransprüchen und der nachfolgenden Beschreibung, in der unter Bezugnahme auf die Zeichnungen mehrere Ausführungsbeispiele im Einzelnen beschrieben sind. Dabei können die in den Ansprüchen und in der Beschreibung erwähnten Merkmale jeweils einzeln für sich oder in beliebiger Kombination erfindungswesentlich sein.
- Fig. 1: zeigt einen Schnitt durch ein erstes Ausführungsbeispiel eines erfindungsgemäßen Strukturbauteils, und
- Fig. 2: zeigt einen Schnitt durch ein zweites Ausführungsbeispiel eines erfindungsgemäßen Strukturbauteils.

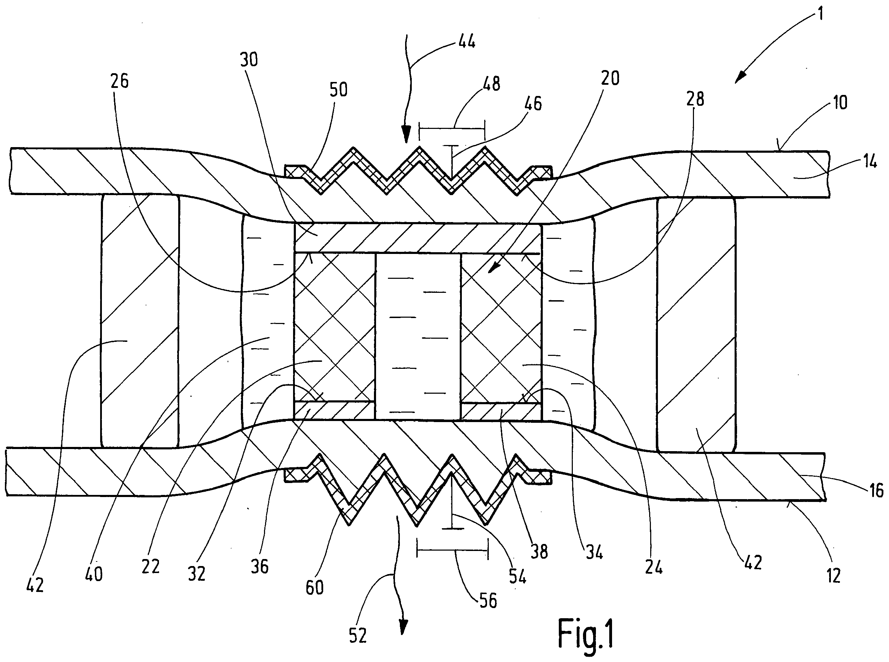

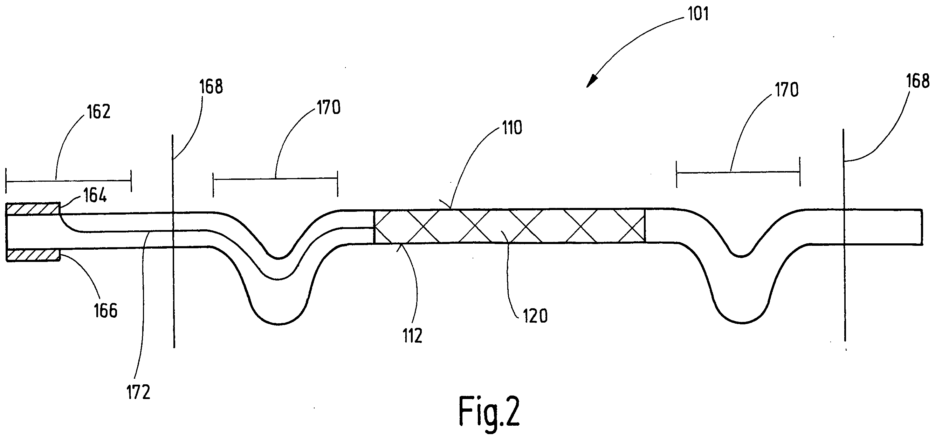

Die Fig. 1 zeigt einen Schnitt durch ein erstes Ausführungsbeispiel eines erfindungsgemäßen Strukturbauteils 1 zur Wärmeabschirmung von Motoren oder Motorkomponenten, im Ausführungsbeispiel eines Hitzeschildes für Verbrennungskraftmaschinen. Das Strukturbauteil 1 hat eine flächige Ausdehnung und erstreckt sich insbesondere auch senkrecht zur Zeichenebene der Fig. 1. Das Strukturbauteil 1 weist eine erste Seite 10 auf, die einem heißen Bauteil des nicht dargestellten Motors zugewandt ist, und eine zweite Seite 12, die dem heißen Bauteil des Motors abgewandt ist. Die erste Seite 10 ist dabei von einer ersten Lage 14 gebildet und die zweite Seite 12 von einer zweiten Lage 16, wobei die beiden Lagen 14, 16 aus einem Metallblech gebildet sind, beispielsweise aus einem Aluminiumsblech, mit einer Dicke zwischen 0,05 und 2 mm, insbesondere zwischen 0,1 und 0,3 mm oder zwischen 0,3 und 0,8 mm. Die Darstellungen der Figuren 1 und 2 sind nicht maßstäblich, insbesondere ist die Ausdehnung des thermoelektrischen Generators 20 in Bezug auf die Lagen 14, 16 nicht maßstäblich.

Zwischen den beiden Lagen 14, 16 ist ein thermoelektrischer Generator 20 angeordnet, der einen ersten Abschnitt 22 und einen zweiten Abschnitt 24 aufweist. Die beiden Abschnitte 22, 24 sind aus einem halbleitenden thermoelektrischen Werkstoff hergestellt, beispielsweise aus Bismuttellurid (Bi2Te3) oder Bleitellurid (PbTe), und der erste Abschnitt 22 ist p-dotiert und der zweite Abschnitt 24 n-dotiert. Der erste Abschnitt 22 weist ein erstes Ende 26 auf, das über eine Verbindungsbrücke 30 mit einem ersten Ende 28 des zweiten Abschnitts 24 elektrisch verbunden ist. Die Verbindung kann im einfachsten Fall durch kraftbelastete Anlage der beiden Abschnitte 22, 24 an der Verbindungsbrücke 30 bereitgestellt sein. Die Verbindungsbrücke 30 kann in Dick- oder Dünnschichttechnik auf der ersten Lage 14 aufgebracht sein, entweder strukturiert, beispielsweise mittels Siebdruck, oder ganzflächig mit anschließender Strukturierung. Auch die beiden Abschnitte 22, 24 können in Dick- oder Dünnschichttechnik aufgebracht sein. Die ersten Enden 26, 28 des ersten Abschnitts 22 und zweiten Abschnitts 24 sind dabei in wärmeleitender Verbindung mit der ersten Lage 14.

Der erste Abschnitt 22 weist ein zweites Ende 32 auf, das in wärmeleitender Verbindung mit der zweiten Lage 16 ist. Außerdem ist das zweite Ende 32 in elektrischer Verbindung mit der ersten Anschlusselektrode 36, die in Dick- oder Dünnschichttechnik auf der zweiten Lage 16 aufgebracht sein kann, entweder strukturiert, beispielsweise durch Siebdruck, oder ganzflächig mit anschließender Strukturierung. In entsprechender Weise ist das zweite Ende 34 des zweiten Abschnitts 24 mit einer zweiten Anschlusselektrode 38 verbunden. Über die beiden Anschlusselektroden 36, 38, die sich im Ausführungsbeispiel senkrecht zur Zeichenebene der Fig. 1 erstrecken, kann eine elektrische Verbindung mit weiteren Abschnitten des thermoelektrischen Generators 20 und/oder zu einem Bordnetz des Fahrzeugs hergestellt sein. Insbesondere können die beiden Anschlusselektroden 36, 38 vorzugsweise einstückig Verbindungsleitungen ausbilden, die zu einem Rand des Strukturbauteils 1 und zu einem dort angeordneten Anschlussbereich 162 (Fig. 2) führen.

Der Bereich zwischen den Abschnitten 22, 24 des thermoelektrischen Generators 20 ist mit einem elektrisch isolierenden und eine geringe thermische Wärmeleitung aufweisenden Isolationswerkstoff 40 ausgefüllt, beispielsweise mit Glas, Schaum oder Silicon. Der Isolationswerkstoff 40 umgibt dabei vollflächig die beiden Abschnitte 22, 24 und schließt auch an die einander gegenüberliegenden Lagen 14, 16 an bzw. an der Verbindungsbrücke 30 und den Anschlusselektroden 36, 38. Dadurch wird das Eindringen von Verunreinigungen, insbesondere von Feuchtigkeit zuverlässig verhindert.

Die beiden Lagen 14, 16 überlappen den thermoelektrischen Generator 20 in lateraler Richtung, bleiben aber auch in einem an dem thermoelektrischen Generator 20 angrenzenden Bereich thermisch voneinander isoliert. Zu diesem Zweck sind die beiden Lagen 14, 16 in einem an den thermoelektrischen Generator 20 angrenzenden Bereich durch einen thermischen Isolationswerkstoff 42 voneinander beabstandet. Grundsätzlich kann der thermische Isolationswerkstoff 42 aus demselben Werkstoff wie der Isolationswerkstoff 40 im Bereich der Abschnitte 22, 24 des thermoelektrischen Generators 20 hergestellt sein und sogar einstückig mit diesem ausgebildet sein. In dem dargestellten Ausführungsbeispiel ist der thermische Isolationswerkstoff 42 jedoch beabstandet von dem Isolationswerkstoff 40 und dient außerdem als Abstandshalter. Der thermische Isolationswerkstoff 42 kann insbesondere auf die beiden Lagen 14, 16 wirkende Druckkräfte aufnehmen und von dem thermoelektrischen Generator 20 abhalten. Der thermische Isolationswerkstoff 42 kann beispielsweise aus Glas, Keramik oder Schaum hergestellt sein. Es kommt auch der Einsatz hochporöser Keramiken in Betracht, die eine hohe mechanische Festigkeit bei vergleichsweise geringer thermischer Leitfähigkeit aufweisen.

Die erste Lage 14 weist eine die Absorption der Wärmestrahlung und/oder Wärmekonvektion 44 fördernde Oberflächentopographie auf. Im dargestellten Ausführungsbeispiel wird dies durch eine Prägung der Oberfläche der ersten Seite 10 bereitgestellt, wobei die Prägetiefe 46 zwischen 25 und 200 % des Abstands 48 zweier benachbarter Maxima beträgt, vorzugsweise zwischen 50 und 100 %. Alternativ oder ergänzend ist auf die erste Seite 10 mindestens abschnittsweise im Bereich des thermoelektrischen Generators 20 eine die Wärmeaufnahme fördernde Beschichtung 50 aufgebracht, beispielsweise eine dunkle oder schwarze Eloxierung der aus Aluminium hergestellten erste Lage 14.

In entsprechender Weise weist die zweite Lage 16 im Bereich des thermoelektrischen Generators 20 eine die Wärmeableitung 52 fördernde Oberflächentopographie auf, die im dargestellten Ausführungsbeispiel durch Prägung der zweiten Lage 16 hergestellt ist. Die Prägetiefe 54 beträgt zwischen 25 und 200 % des Abstands 56 zweier benachbarter Maxima, insbesondere zwischen 50 und 100 %. Die Prägetiefe 54 der zweiten Lage 16 kann dabei um 10 bis 100 %, vorzugsweise um 20 bis 80 % höher liegen als die Prägetiefe 46 der ersten Lage 14, um trotz eines geringeren Temperaturgradienten auf der kalten zweiten Seite 12 eine ausreichende Wärmeableitung 52 bereitzustellen. Alternativ oder ergänzend ist auf die zweite Seite 12 mindestens abschnittsweise im Bereich des thermoelektrischen Generators 20 eine die Wärmeableitung 52 fördernde Beschichtung 60 aufgebracht, im Ausführungsbeispiel eine dunkle oder schwarze Eloxierung der aus Aluminium bestehenden zweiten Lage.

Die Fig. 2 zeigt einen Schnitt durch ein zweites Ausführungsbeispiel eines erfindungsgemäßen Strukturbauteils 101. In lateraler Richtung von dem thermoelektrischen Generator 120 beabstandet, insbesondere randseitig, weist das Strukturbauteil 101 einen Anschlussabschnitt 162 auf, an dem die von dem thermoelektrischen Generator 120 erzeugte elektrische Energie abgreifbar ist. Zu diesem Zweck sind im Bereich des Anschlussabschnitts 162 flächige Anschlusselektroden 164, 166 vorgesehen, im dargestellten Ausführungsbeispiel eine erste Anschlusselektrode 164 auf der ersten Seite 110 und eine zweite Anschlusselektrode 166 auf der zweiten Seite 112. Mit den Anschlusselektroden 164, 166 ist eine weiterführende Anschlussleitung verbindbar, beispielsweise eine Anschlussleitung zu dem elektrischen Bordnetz des Fahrzeugs. Über eine zwischen der ersten Seite 110 und der zweiten Seite 112 verlaufende Verbindungsleitung 172 ist die erste Anschlusselektrode 164 mit dem thermoelektrischen Generator 120 verbunden. Die zweite Anschlusselektrode 166 ist über eine die zweite Seite 112 bildende metallische Lage des Strukturbauteils 101 mit dem thermoelektrischen Generator 120 verbunden.

Das Strukturbauteil 101 ist mittels nur schematisch dargestellter Befestigungselemente 168 beispielsweise im Motorraum eines Fahrzeuges festlegbar, vorzugsweise lösbar festlegbar. Die Befestigungselemente 168 können beispielsweise durch Klammern oder Nieten gebildet sein, mittels denen das Strukturbauteil 101 lösbar befestigbar ist.

Das Strukturbauteil 101 weist mindestens zu einer Seite, im Ausführungsbeispiel zu beiden Seiten, des thermoelektrischen Generators 120 einen Kompensationsabschnitt 170 auf, der lateral zwischen dem thermoelektrischen Generator 120 und dem Befestigungselement 168 angeordnet ist. Kommt es infolge der Wärmeeinstrahlung zu einer Ausdehnung des Strukturbauelements 110 insbesondere im Bereich des thermoelektrischen Generators 120 in lateraler Richtung, kann dies von den im Ausführungsbeispiel durch Sicken gebildeten Kompensationsabschnitten 170 aufgenommen werden, ohne dass im Bereich des thermoelektrischen Generators 120 unzulässig hohe mechanische Spannungen auftreten. Erforderlichenfalls ist es auch möglich, einen weiteren Kompensationsabschnitt zwischen dem Befestigungselement 168 und dem Anschlussabschnitt 162 vorzusehen.

## Patentansprüche

1. Abschirmteil (1; 101) zur Wärmeabschirmung von Motoren oder Motorkomponenten, insbesondere Hitzeschild für Verbrennungskraftmaschinen, wobei das Abschirmteil (1; 101) mehrlagig ausgebildet ist und eine flächige Ausdehnung hat und eine eine erste Seite (10; 110) bildende erste Lage (14) aufweist, die einem heißen Bauteil des Motors zugewandt ist, und eine eine zweite Seite (12; 112) bildende zweite Lage (16) aufweist, die dem heißen Bauteil des Motors abgewandt ist,
wobei die beiden Lagen (14, 16) aus einem Metallblech mit einer Dicke zwischen 0,1 mm und 2 mm ausgebildet sind, **dadurch gekennzeichnet, dass** das Abschirmteil (1; 101) einen thermoelektrischen Generator (20; 120) aufweist, mit dem aus einer sich im Betrieb des Motors ergebenden Temperaturdifferenz zwischen der ersten Seite (10; 110) und der zweiten Seite (12; 112) des Abschirmteils (1; 101) elektrische Energie erzeugbar ist,
wobei der thermoelektrische Generator (20; 120) zwischen den beiden Lagen (14, 16) angeordnet ist, mit beiden Lagen (14, 16) in wärmeleitender Verbindung ist und die beiden Lagen (14, 16) des Abschirmteils (1; 101) den thermoelektrischen Generator (20; 120) in lateraler Richtung überlappen und in einem an den thermoelektrischen Generator (20; 120) angrenzenden Bereich voneinander thermisch isoliert sind und zu diesem Zweck durch einen thermischen Isolationswerkstoff (42) voneinander beabstandet sind.

2. Abschirmteil nach Anspruch 1, **dadurch gekennzeichnet, dass** der thermoelektrische Generator (20; 120) einen ersten Abschnitt (22) und einen zweiten Abschnitt (24) aufweist, die jeweils ein erstes Ende (26, 28) und ein zweites Ende (32, 34) aufweisen, dass die beiden Abschnitte (22, 24) unterschiedliche Werkstoffe oder unterschiedliche Werkstoffkombinationen aufweisen und/oder unterschiedlich dotiert sind, dass die erste Enden (26, 28) der beiden Abschnitte (22, 24) elektrisch miteinander verbunden und in wärmeleitender Verbindung mit einer der beiden Seiten (10, 12; 110, 112) des Abschirmteils (1; 101) sind, und dass die zweiten Enden (32, 34) der beiden Abschnitte (22, 24) in wärmeleitender Verbindung mit der anderen der beiden Seiten (10, 12; 110, 112) des Abschirmteils (1; 101) sind.

3. Abschirmteil nach Anspruch 1 oder 2, **dadurch gekennzeichnet, dass** der thermoelektrische Generator (20; 120) voneinander beabstandete Abschnitte (22, 24) aufweist, und dass der Bereich zwischen den Abschnitten (22, 24) mindestens teilweise durch einen thermischen Isolationswerkstoff (40) ausgefüllt ist.

4. Abschirmteil) nach Anspruch 1, **dadurch gekennzeichnet, dass** elektrische Anschlussleitungen (172) des thermoelektrischen Generators (20; 120) mindestens abschnittsweise zwischen den beiden Lagen (14, 16) des Abschirmteils (1; 101) geführt sind.

5. Abschirmteil nach Anspruch 1 bis 4, **dadurch gekennzeichnet, dass** mindestens eine der beiden Lagen (14, 16) des Abschirmteils (1; 101) auf ihrer dem thermoelektrischen Generator (20; 120) zugewandten Seite Anschlusselektroden (36, 38) zur elektrischen Kontaktierung des thermoelektrischen Generators (20; 120) und/oder elektrische Leiterbahnen aufweist.

6. Abschirmteil nach einem der vorgenannten Ansprüche, **dadurch gekennzeichnet, dass** die erste Seite (10; 110) des Abschirmteils (1; 101 ), insbesondere die erste Lage (14) des mehrlagigen Abschirmteils (1; 101), mindestens bereichsweise eine die Wärmeabsorption und/oder Wärmeaufnahme fördernde Beschichtung (50) und/oder Oberflächentopographie aufweist.

7. Abschirmteil nach einem der vorgenannten Ansprüche, **dadurch gekennzeichnet, dass** die zweite Seite (12; 112) des Abschirmteils (1; 101), insbesondere eine zweite Lage (14) eines mehrlagigen Abschirmteils (1; 101), mindestens bereichsweise eine die Wärmeabstrahlung und/oder Wärmeableitung fördernde Beschichtung (60) und/oder Oberflächentopographie aufweist.

8. Abschirmteil nach einem der vorgenannten Ansprüche, **dadurch gekennzeichnet, dass** das Abschirmteil (1; 101) einen Anschlussabschnitt (162) aufweist, an dem die von dem thermoelektrischen Generator (20; 120) erzeugte elektrische Energie abgreifbar ist.

9. Abschirmteil nach einem der vorgenannten Ansprüche, **dadurch gekennzeichnet, dass** das Abschirmteil (1; 101) einen Kompensationsabschnitt (170) aufweist, mittels dem eine temperaturbedingte Änderung der Ausdehnung des Abschirmteils (1; 101) derart kompensierbar ist, dass ein Festlegeabschnitt zum Befestigen des Abschirmteils (1; 101), und/oder ein Anschlussabschnitt (162), an dem die von dem thermoelektrischen Generator (20; 120) erzeugte elektrische Energie abgreifbar ist, keine unzulässigen mechanischen Spannungen erfährt.

10. Abschirmteil nach einem der vorgenannten Ansprüche, **dadurch gekennzeichnet, dass** der thermoelektrische Generator (20; 120) mindestens teilweise in Dick- oder Dünnschichttechnik hergestellt ist, insbesondere in Dick- oder Dünnschichttechnik flächig auf das Abschirmteil (1; 101) aufgebracht ist.

11. Abschirmteil nach einem der vorgenannten Ansprüche, **dadurch gekennzeichnet, dass** der thermoelektrische Generator (20; 120) mindestens teilweise durch polymerelektronische thermoelektrische Abschnitte gebildet ist.

12. Abschirmteil nach einem der vorgenannten Ansprüche, **dadurch gekennzeichnet, dass** der thermoelektrische Generator (20; 120) durch Anschluss an eine elektrische Energiequelle auch als Wärmepumpe betreibbar ist.

## Claims

1. A shielding component (1; 101) for heat shielding of engines or engine components, in particular a heat shield for internal combustion engines; the shielding component (1; 101) is embodied as multilayered, extends over a broad expanse, and has a first layer (14) comprising a first side (10; 110) that is oriented toward a hot component of the engine and a second layer (16) comprising a second side (12; 112) that is oriented away from the hot component of the engine,
the two layers (14, 16) are composed of a metal sheet with a thickness of between 0.1 mm and 2 mm,
**characterized in that** the shielding component (1; 101) has a thermoelectric generator (20; 120) with which it is possible to generate electrical energy from a temperature difference between the first side (10; 110) and the second side (12; 112) of the shielding component (1; 101) that is produced during operation of the engine,
the thermoelectric generator (20; 120) is positioned between the two layers (14, 16) and connected to the two layers (14, 16) in a thermally conducting fashion and the two layers (14, 16) of the shielding component (1; 101) overlap the thermoelectric generator (20; 120) in the lateral direction and are thermally insulated from each other in a region adjoining the thermoelectric generator (20; 120) and for this purpose, are separated from each other by a thermal insulation material (42).

2. The shielding component according to claim 1, **characterized in that** the thermoelectric generator (20; 120) has a first section (22) and a second section (24), which each have a first end (26, 28) and a second end (32, 34); the two sections (22, 24) have different materials or different material combinations and/or are differently doped; the first ends (26, 28) of the two sections (22, 24) are electrically connected to each other and are connected in a thermally conducting fashion to one of the two sides (10, 12; 110, 112) of the shielding component (1; 101); and the second ends (32, 34) of the two sections (22, 24) are connected in a thermally conducting fashion to the other of the two sides (10, 12; 110, 112) of the shielding component (1; 101).

3. The shielding component according to claim 1 or 2, **characterized in that** the thermoelectric generator (20; 120) has sections (22, 24) that are spaced apart from each other and the region between the sections (22, 24) is at least partially filled by a thermal insulation material.

4. The shielding component according to claim 1, **characterized in that** in at least some sections, electric connecting lines (172) of the thermoelectric generator (20; 120) are routed between the two layers (14, 16) of the shielding component (1; 101).

5. The shielding component according to claims 1 through 4, **characterized in that** at least one of the two layers (14, 16) of the shielding component (1; 101), on its side oriented toward the thermoelectric generator (20; 120), has connecting electrodes (36, 38) for electrically contacting the thermoelectric generator (20; 120) and/or electrical conductor paths.

6. The shielding component according to one of the preceding claims, **characterized in that** the first side (10; 110) of the shielding component (1; 101), in particular the first layer (14) of the multilayered shielding component (1; 101), has a coating (50) and/or surface topography in at least some regions that promotes thermal absorption and/or heat absorption.

7. The shielding component according to one of the preceding claims, **characterized in that** the second side (12; 112) of the shielding component (1; 101), in particular a second layer (14) of a multilayered shielding component (1; 101), has a coating (60) and/or surface topography at least in some areas that promotes heat radiation and/or heat dissipation.

8. The shielding component according to one of the preceding claims, **characterized in that** the shielding component (1; 101) has a connecting section (162) at which the electrical energy produced by the thermoelectric generator (20; 120) can be picked up.

9. The shielding component according to one of the preceding claims, **characterized in that** the shielding component (1; 101) has a compensating section (170) by means of which it is possible to compensate for a temperature-dependent change in the dimensions of the shielding component (1; 101) in such a way that an immobilizing section for fastening the shielding component (1; 101) and/or a connecting section (162) at which the electrical energy produced by the thermoelectric generator (20; 120) can be picked up is/are not subjected to any impermissible mechanical stresses.

10. The shielding component according to one of the preceding claims, **characterized in that** at least in some regions, the thermoelectric generator (20; 120) is produced by means of thick-film or thin-film technology, in particular is applied to a broad expanse of the shielding component (1; 101) by means of thick-film or thin-film technology.

11. The shielding component according to one of the preceding claims, **characterized in that** the thermoelectric generator (20; 120) is at least partially composed of polymer electronic thermoelectric sections.

12. The shielding component according to one of the preceding claims, **characterized in that** it is also possible to operate the thermoelectric generator (20; 120) as a heat pump by connecting it to an electrical energy source.

## Revendications

1. Pièce de blindage (1 ; 101) pour le blindage thermique de moteurs ou de composants de moteur, en particulier bouclier thermique pour des moteurs à combustion interne, la pièce de blindage (1 ; 101) étant réalisée en plusieurs couches et présentant une extension surfacique et comprenant une première couche (14) formant une première face (10 ; 110) qui est tournée vers un composant chaud du moteur, et une seconde couche (16) formant une seconde face (12 ; 112) qui est détournée du composant chaud du moteur,
les deux couches (14, 16) étant réalisées en une tôle métallique d'une épaisseur comprise entre 0,1 mm et 2 mm,
**caractérisée en ce que** la pièce de blindage (1 ; 101) comprend un générateur thermoélectrique (20 ; 120) permettant de générer de l'énergie électrique à partir d'une différence de température qui se produit entre la première face (10 ; 110) et la seconde face (12 ; 112) de la pièce de blindage (1 ; 101) pendant le fonctionnement du moteur,
dans laquelle le générateur thermoélectrique (20 ; 120) est agencé entre les deux couches (14, 16) et est en liaison thermoconductrice avec les deux couches (14, 16), et les deux couches (14, 16) de la pièce de blindage (1 ; 101) chevauchent le générateur thermoélectrique (20 ; 120) en direction latérale et sont isolées thermiquement l'une de l'autre dans une zone adjacente au générateur thermoélectrique (20 ; 120) et sont à cet effet écartées l'une de l'autre par un matériau d'isolation thermique (42).

2. Pièce de blindage selon la revendication 1, **caractérisée en ce que** le générateur thermoélectrique (20 ; 120) comprend une première portion (22) et une seconde portion (24) qui présentent chacune une première extrémité (26, 28) et une seconde extrémité (32, 34), **en ce que** les deux portions (22, 24) présentent différents matériaux ou différentes combinaisons de matériaux et/ou sont dopées différemment, **en ce que** les premières extrémités (26, 28) des deux portions (22, 24) sont électriquement connectées l'une à l'autre et en liaison thermoconductrice avec l'une des deux faces (10, 12 ; 110, 112) de la pièce de blindage (1 ; 101), et **en ce que** les secondes extrémités (32, 34) des deux portions (22, 24) sont en liaison thermoconductrice avec l'autre des deux faces (10, 12 ; 110, 112) de la pièce de blindage (1 ; 101).

3. Pièce de blindage selon la revendication 1 ou 2, **caractérisée en ce que** le générateur thermoélectrique (20 ; 120) comprend des portions (22, 24) écartées l'une de l'autre et **en ce que** la zone entre les portions (22, 24) est remplie au moins partiellement avec un matériau d'isolation thermique (40).

4. Pièce de blindage selon la revendication 1, **caractérisée en ce que** les lignes de connexion électriques (172) du générateur thermoélectrique (20 ; 120) sont menées au moins localement entre les deux couches (14, 16) de la pièce de blindage (1 ; 101).

5. Pièce de blindage selon la revendication 1 à 4, **caractérisée en ce que** l'une au moins des deux couches (14, 16) de la pièce de blindage (1 ; 101) comprend sur sa face tournée vers le générateur thermoélectrique (20 ; 120) des électrodes de connexion (36, 38) pour la mise en contact électrique du générateur thermoélectrique (20 ; 120) et/ou des pistes conductrices électriques.

6. Pièce de blindage selon l'une des revendications précédentes, **caractérisée en ce que** la première face (10 ; 110) de la pièce de blindage (1 ; 101), en particulier la première couche (14) de la pièce de blindage (1 ; 101) multicouche, comprend au moins localement un revêtement (50) et/ou une topographie de surface qui favorise l'absorption de chaleur et/ou l'accumulation de chaleur.

7. Pièce de blindage selon l'une des revendications précédentes, **caractérisée en ce que** la seconde face (12 ; 112) de la pièce de blindage (1 ; 101), en particulier la seconde couche (14) de la pièce de blindage (1 ; 101) multicouche, comprend au moins localement un revêtement (60) et/ou une topographie de surface qui favorise la radiation de chaleur et/ou la dissipation de chaleur.

8. Pièce de blindage selon l'une des revendications précédentes, **caractérisée en ce que** la pièce de blindage (1 ; 101) comprend une portion de connexion (162) sur laquelle l'énergie électrique générée par le générateur thermoélectrique (20 ; 120) peut être prélevée.

9. Pièce de blindage selon l'une des revendications précédentes, **caractérisée en ce que** la pièce de blindage (1 ; 101) comprend une portion de compensation (170) au moyen de laquelle un changement de l'extension de la pièce de blindage (1 ; 101) dû à la température peut être compensé de telle sorte qu'une portion d'immobilisation pour fixer la pièce de blindage (1 ; 101) et/ou une portion de connexion (162) sur laquelle l'énergie électrique générée par le générateur thermoélectrique (20 ; 120) peut être prélevée ne subit pas de contraintes mécaniques inadmissibles.

10. Pièce de blindage selon l'une des revendications précédentes, **caractérisée en ce que** le générateur thermoélectrique (20 ; 120) est réalisé au moins partiellement par la technique des couches épaisses ou des couches minces, et **en ce qu'**il est en particulier déposé en surface sur la pièce de blindage (1 ; 101) par la technique des couches épaisses ou des couches minces.

11. Pièce de blindage selon l'une des revendications précédentes, **caractérisée en ce que** le générateur thermoélectrique (20 ; 120) est formé au moins partiellement par des portions thermoélectriques d'électronique polymère.

12. Pièce de blindage selon l'une des revendications précédentes, **caractérisée en ce que** par la connexion à une source d'énergie électrique, le générateur thermoélectrique (20 ; 120) est susceptible de fonctionner également comme pompe à chaleur.
